# EUROPEAN PATENT APPLICATION

(11) **EP 4 808 292 A1**
(43) Date of publication of application: **16.09.2026**
(21) Application number: 25162694.1
(22) Date of filing: 10.03.2025
(51) Int. Cl.: H05K 3/34, B41F 16/00, B41M 5/025, H05K 3/32, H05K 3/12

(54) **METHOD FOR TRANSFERRING A PATTERN, AND PRINTING DEVICE**

(71) Applicant: FononTech Holding B.V., 5656 AE Eindhoven (NL)
(72) Inventor: HENDRIKS, Rob Jacob, 5656 AE Eindhoven (NL); KOLDEWEIJ, Robin Bernardus Johannes, 5656 AE Eindhoven (NL)
(74) Representative: V.O.

(57) **Abstract**

Disclosed is a method and printing device for transferring a pattern from a support surface onto a target surface. A low viscous substance with at least two phases, i.e. a carrier material and a functional material, is applied onto the support surface. The support surface comprises first and second zones that respectively attract and repel the substance, thereby patterning the applied substance. The substance comprises at least one low vapor pressure material and at least one high vapor pressure material. The viscosity of the patterned substance is initially increased by at least partially evaporating the low vapor pressure material, before a part of the high vapor pressure material is rapidly evaporated with a high heat flux at its contact surface with the support surface, to transfer the patterned substance.

## Description

The invention relates to a method for transferring a pattern from a support surface onto a target surface, in particular a non-contact printing method. The invention further relates to a printing device for printing a low viscous substance with a pattern onto a target surface.

### BACKGROUND

As known in the art heat induced deposition from a donor surface to a target surface is in principle applicable for a wide range of purposes. In this approach the donor surface of a donor plate is rapidly heated. Therewith the generated heat serves to evaporate a deposition agent so as to induce an evaporation that propels a donor element from the donor surface to the target surface.

The deposition agent is for example present in a formulation comprising the donor element to be deposited.

A formulation can e.g. be formed by dispersing a functional material constituting the donor element to be deposited in a solvent or liquid; thus, the formulation is generally wet. The formulation is often referred to as an ink or paste, depending on the viscosity. Examples thereof are a conductive adhesive comprising a thermal or UV settable resin loaded with silver particles, or a solder paste comprising solder particles and flux. Alternatively, the functional material may be of a non-conductive nature so as to provide an insulating element on the target surface. A challenge exists to transfer such functional materials, since ideally, instead of printing a functional ink material on a substrate, selectively depositing only the pure functional material on a substrate is most preferable. Due to their highly viscous nature, e.g. higher than 50 Pa/s to even as much about 1000 Pa/s (10^6 cps). Such materials will not significantly deform due to gravity and flow, but substantial maintain the intended aspect ratio and form definition in the transfer.

EP 4037442 A1 discloses an example of such a heat induced deposition method.

However, in some cases non-contact transfer of high resolution patterns using rapid surface heating can be problematic. When using low viscous materials, high resolution lines may break up onto droplets before reaching the acceptor substrate. When features become smaller, low viscous material become unstable during transfer (splashing). This makes it difficult to transfer highly defined non-droplet shaped patterns with low viscous materials.

Conversely, when using (ultra-)high viscous materials, it can be problematic to apply the material onto a transfer plate in a high resolution pattern due to high shear forces.

### SUMMARY

In one aspect, the invention provides a method for transferring a pattern from a support surface onto a target surface, as defined in the appended claims. The method comprises:
(i) applying a low viscous substance, with at least two phases, i.e. a carrier material and a functional material, onto the support surface. The support surface comprises first zones that attract the substance and second zones that repel the substance, for thereby patterning the substance when applied on the support surface. The substance comprises at least one low vapor pressure material and at least one high vapor pressure material;
(ii) increasing a viscosity of the patterned substance, by at least partially evaporating the high vapor pressure material, e.g. in a drying step. This can for example be achieved by controlling a relative temperature or pressure between the substance and the environment, and/or by diffusion;
(iii) rapidly evaporating a part of the low vapor pressure material with a high heat flux, preferably a heat flux of at least 10 kW/cm2, at its contact surface with the support surface, for therewith inducing an evaporation that causes a transfer of a remainder of the patterned substance towards the target surface.

The proposed solution thus starts with a low viscous substance, e.g. an ink, which is patterned by the attracting and repelling qualities of the first and second zones on the support surface, after which the substance is converted into a high viscous layer before being transferred to the target surface.

Accordingly, a three stage process is provided to transfer a substance with at least two phases, i.e. a carrier material and a functional material, with a high resolution pattern.

By applying the substance with a low viscosity onto the support surface, or transfer plate, which has a pattern of substance attracting first zones and substance repelling second zones, the patterned support surface fixates the applied substance in the desired pattern. More specifically, when the low viscous substance (e.g. ink), preferably having a high surface energy, is applied onto the patterned support surface, only on the first zones the substance will stick, whereas adjacent second zones repel the substance so that it is directed towards the first zones, resulting in a highly defined pattern of applied substance. Due to the definition of first and second zones on the support surface, the substance does not tend to flow out and instead assumes a relatively high contact angle with the support surface.

Preferably, the surface energy difference between the first and second zones should be such that a contact angle difference of at least 20° occurs between them. Preferably, at room temperature there is a vapor pressure difference between the low vapor pressure material and the high vapor pressure material of at least 25 mbar.

In preferred embodiments, the first zones on the support surface are hydrophilic and the second zones on the support surface are hydrophobic. As disclosed herein, the terms "hydrophilic" and "hydrophobic" not only relate to effects that occur with substances that include water, but also with substances that include other types of materials which can be either attracted to or repelled by the zones, e.g. non-polar substances. The "hydrophilic" and "hydrophobic" effect of the zones can be obtained by locally coating the support surface with specific materials which have substance repelling or substance attracting properties. Alternatively, or additionally, the first and second zones may have distinct surface roughness. In the first zones, where the support surface attracts the substance, the apparent contact angle will decrease as the solid surface roughness increases and the substance attracting quality is better. Where the support surface repels the substance in the second zones, the apparent contact angle will increase with the solid surface roughness.

In stage two of the method of the present invention, a processing step is used to at least partially evaporate the high vapor pressure material to densify the substance, increasing its viscosity significantly, but preventing any transfer or bubble formation. Thus, after applying the low viscous substance or ink, a step is introduced to partially dry or cure the substance. In other words, using a low energy or heat flux the substance is partially cured or dried in a non-explosive and non-boiling fashion. The step of increasing the viscosity of the applied substance can e.g. be performed by heating up the substance using a heater plate attached to or embedded in the support surface, and/or by curing the material, e.g. using an external light source or a curing agent.

This increases the viscosity of the substance, which ensures that any lines and patterns can be transferred without the substance breaking up into undefined droplets. To increase the control over the drying process, the substance comprises at least one material with a low vapor pressure and at least one with a high vapor pressure. This results in a more self-limited drying process.

In the third stage of the method a second thermal processing step is performed that rapidly evaporates a part of the low vapor pressure material at the interface to transfer the patterned high viscous substance onto a target surface, e.g. of an acceptor substrate, using a high heat flux.

In comparison with known non-contact printing methods like impulse printing technology, e.g. using grooves and heat spreaders, the present approach differs in that it starts with a low viscous material which is converted into a high viscous material during the process. An advantage of the present method is that the lower viscous material is easier to handle and apply onto the support surface, in comparison to (ultra) high viscous materials. High viscous materials with fillers, such as metal particles, can be very sticky and difficult to apply. In comparison with known impulse printing methods that use engraved structures and heat spreaders, there are intrinsically no shear forces with the present approach, whereas a conventional heat spreader approach, for example, needs to have a uniform heat flux distribution in order to print without shear forces.

In preferred embodiments of the present invention, the method further comprises the step of providing a resistive heater layer on the support surface, and at least the step of rapidly evaporating the substance is performed by the resistive heater layer. The step of increasing the viscosity of the patterned substance can be performed by the resistive heater layer too.

Preferably, the viscosity of the applied substance is increased by heating the substance to a first temperature during a first time period, whereas the step of rapidly evaporating the substance is performed by heating a part of the substance to a second temperature during a second time period. The second temperature is higher than the first temperature, and the second time period is shorter than the first time period. For example, the first temperature is lower than a boiling temperature of the high vapor pressure material, and the second temperature is higher than a vaporization temperature of the low vapor pressure material. In other words, the step of increasing the viscosity is performed with a relatively low heat flux, to prevent any transfer and/or bubble formation in this step, and the step of rapidly evaporating is performed with a relatively high heat flux, e.g. by pulse heating the material, to transfer the material to the acceptor substrate. Alternatively, or additionally, the environmental pressure can be lowered, such that the (conditioned) temperature is sufficiently high to evaporate the carrier material, but not the functional material.

The step of rapidly evaporating is not necessarily performed immediately after the step of increasing the viscosity. These steps may be separated by a certain time period. For example, the support surface including the material applied thereon may be pre-treated by increasing the viscosity of the material, and then stored. Between the steps of increasing the viscosity and rapidly evaporating the patterned substance, the method optionally comprises the step of cooling the support surface to maintain the support surface at a predetermined temperature. The viscosity of liquids usually increases rapidly when the temperature decreases. In this way the viscosity of the material can be controlled, and maintained at a value that is optimal for transferring the material. Maintaining the temperature may involve both cooling as well as heating the support surface. Optionally, the ambient pressure can be increased to increase the vaporization temperature of the functional material.

In case the substance is water-based, the water causes the substance to have a relatively high surface energy. To ensure controlled drying, glycerol could be added to such a water based substance, as it has a high vapor pressure. In more general terms, the substance may be a water based ink or an ink comprising an organic compound, wherein the organic compound is preferably a polyol, e.g. glycerol. This would ensure partial drying where it is still possible to transfer the pattern with a high heat flux pulse. These types of material typically have a relatively high boiling temperature and vaporization temperature, which promotes accurate transfer of the pattern. Furthermore, their solubility in water is generally good.

To facilitate application and patterning of the substance onto the support surface, the substance is preferably applied onto the support surface with a relatively low initial viscosity, e.g. a viscosity less than 10 Pascal-second at 20 degrees Celsius.

Other aspects the invention provide a printing device for printing a low viscous substance with a pattern onto a target surface, as defined in the appended claims. The printing device may be arranged for performing the method described herein. Conversely, the method may be performed by the printing device described herein.

The low viscous substance to be printed has at least two phases, i.e. a carrier material and a functional material. The substance comprises a low vapor pressure material and a high vapor pressure material.

The printing device includes a support surface onto which the substance is to be applied, a heater facility, and a controller.

The support surface comprises first zones that attract the substance and second zones that repel the substance, for thereby patterning the substance when applied on the support surface. Preferably, the contact angles between the substance and the first zones is between 20 and 80 degrees, and the contact angles between the substance and the second zones is between 100 and 160 degrees.

The heater facility is arranged for heating the applied substance at its contact surface with the support surface. The heater facility e.g. comprises a resistive heater layer that is arranged on the support surface.

The controller is arranged for controlling the heater facility to first increase a viscosity of the patterned substance, by at least partially evaporating the high vapor pressure material with a low heat flux, e.g. in a drying or curing step. After the viscosity is increased, the controller is arranged for subsequently controlling the heater facility to rapidly evaporate a part of the low vapor pressure material with a high heat flux at its contact surface with the support surface, for therewith inducing an evaporation that causes a transfer of a remainder of the patterned substance towards the target surface.

Accordingly, the support surface is provided with a pattern that has first zones with substance attracting, e.g. hydrophilic, properties and second zones with substance repelling, e.g. hydrophobic, properties. In preferred embodiments, the first zones are provided by a first coating, and the second zones are provided by a second coating.

Then, a low viscous substance (ink) with high surface energy is applied onto the patterned support surface. Only in the first zones the substance will stick, resulting in a highly defined pattern of substance.

After application of the low viscous substance, a thermal step is introduced to partially dry or cure the substance. This rapidly increases the viscosity of the substance, which ensures lines and complex patterns (non-droplet shaped) can be transferred without breaking up into undefined droplets. To increase the control over the drying process, the substance preferably includes two types of material: at least one with a low vapor pressure and at least one with a high vapor pressure. This results in a more self-limited drying process.

After increasing the viscosity of the substance, the pattern is transferred through high heat flux, e.g. pulse heating by the rapid heater plate.

Optionally, the printing device further comprises a cooling facility for cooling the support surface. In such embodiments, the controller may be arranged for controlling the heater facility and the cooling facility to maintain the support surface at a predetermined temperature between the steps of increasing the viscosity and rapidly evaporating the patterned substance.

The substance repelling second coating is preferably applied between the support surface and the substance attracting first coating, so that the first coating locally covers the second coating for defining the one or more first and second zones. In other words, the first coating is the outermost layer that covers the second layer. The first coating may be absent in some areas to locally expose the underlying second coating.

The first coating that defines the pattern through self-alignment preferably has a low thermal resistance (high thermal conductivity), otherwise the heat flux towards the contact side of the substance may not be high enough for the transfer process. To reduce the thermal resistance of the coatings, the second coating preferably has a layer thickness of 1-1000 nanometers. The first coating preferably has a layer thickness of 10-100 nanometers. The second coating can for example comprise Silicon dioxide (SiO₂), Silicon Nitride (Si₃N₄), or Aluminium Oxide (Al₂O₃), which have good substance repelling properties and a relatively high thermal conductivity. The first coating preferably comprises at least one of Molybdenum, Tungsten, Tantalum, Copper and Chromium. These substance attracting materials and their alloys and have a relatively high thermal conductivity.

### BRIEF DESCRIPTION OF THE DRAWINGS

The invention will be further elucidated in the figures:
FIG. 1 illustrates a step in which a substance is applied on an embodiment of a support surface of a printing device in accordance with the present invention;
FIG. 2 illustrates the support surface with the substance applied thereon in a pattern;
FIG. 3 illustrates a step in which the viscosity of the patterned substance is increased to a higher viscosity;
FIG. 4 illustrates a step in which the higher viscosity substance is transferred to a target surface;
FIG. 5 represents an embodiment of a method for transferring a substance in accordance with the invention;
FIG. 6 provide a graph of the change in temperature and viscosity of the substance during subsequent steps of the method;
FIG. 7 represents a further embodiment of the method, comprising an optional cooling step.

### DETAILED DESCRIPTION

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

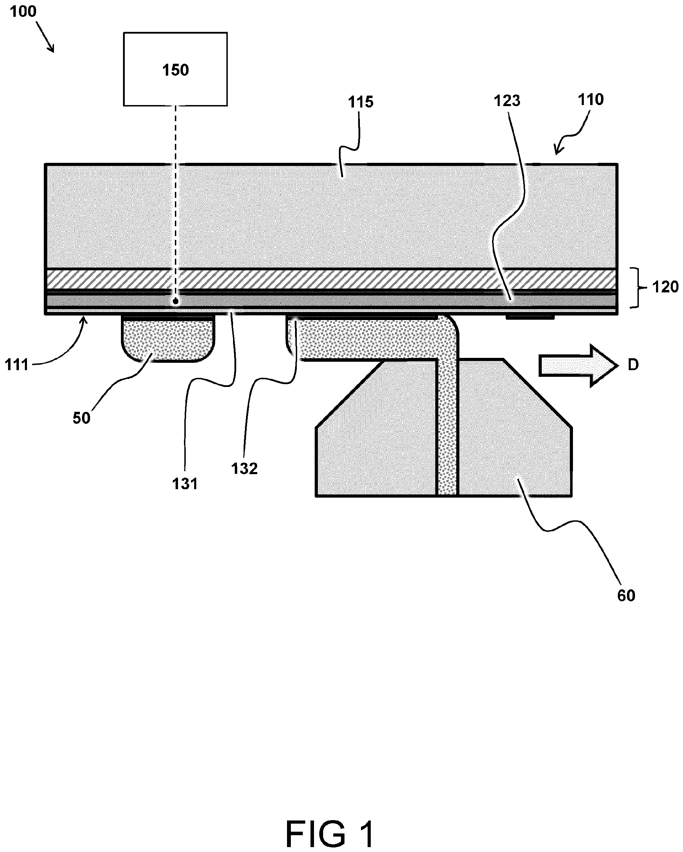

FIG. 1 illustrates an embodiment of a printing device 100, in particular an impulse printing device, arranged for printing a low viscous substance 50, or formulation, with a pattern onto a target surface in a non-contact fashion, e.g. in a heat induced transfer method. In this approach the support surface at the donor side is rapidly heated. Therewith the generated heat serves to evaporate a deposition agent so as to induce an evaporation that propels the substance from the support surface to the target surface. The deposition agent is for example present in the formulation comprising the functional material in the substance that is to be deposited.

The printing device 100 of the present invention is particularly arranged for printing low viscosity fluids, e.g. with a viscosity less than 10 Pascal-second at 20 degrees Celsius. The substance or formulation 50 may for example be an ink, preferably a functional ink in which the donor element is a functional material that is present in a solvent or liquid. Examples of such a functional ink are a conductive adhesive comprising a thermal or UV settable resin loaded with silver particles, or a solder substance comprising solder particles and flux. Alternatively the functional material may be of a non-conductive nature so as to provide an insulating element on the target surface.

The donor element to be deposited and the deposition agent are mutually distinct, in that the formulation 50 comprises a low vapor pressure material and a high vapor pressure material. For example, the deposition agent may have a high vapor pressure, and the donor element may have a low vapor pressure. In that case the vapor pressure induced by heating the deposition agent propels the donor element, e.g. a piece of a donor material or a discrete component from the donor surface towards the target surface. Preferably the formulation 50 is a liquid with a relatively high surface energy, e.g. In preferred embodiments, the formulation comprises a mixture or solution of water and glycerol.

The printing device 100 comprises a support surface 110, with a contact side 111 onto which the formulation, i.e. substance, is to be applied as illustrated in FIG. 1, e.g. by a deposition head 60 in a deposition direction D.

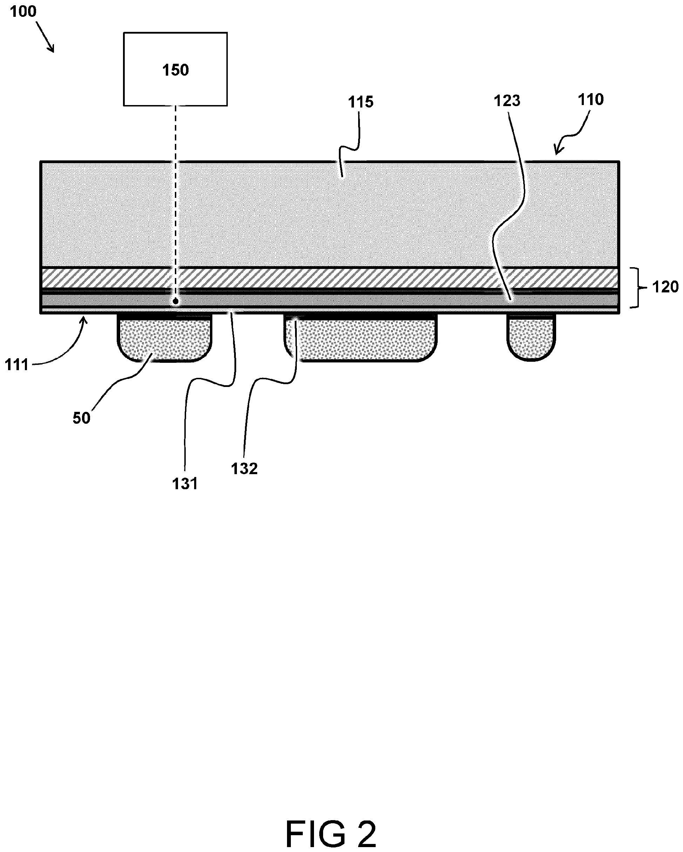

FIG. 2 illustrates the printing device 100 after the substance 50 has been applied on the contact side 111 of the support surface. In this embodiment, the support surface 110 comprises a heater facility 120 attached to a silicon base plate 115. The contact side 111 of the support surface is provided with a first coating 132 and a second coating 131 that provide substance attracting, e.g. hydrophilic, and substance repelling, e.g. hydrophobic, zones on the contact side 111 that attract and repel the substance 50. The hydrophilic and hydrophobic zones are applied in a pattern on the contact side 111. Accordingly, when the substance is applied on the support surface 110, the substance is patterned by the first and second zones. The first and second zones may be created by distinct coatings 131, 132 that are applied directly on the support surface, e.g. in adjacent and complementary patterns. Alternatively, the "hydrophobic" second coating 131 and "hydrophilic" first coating 132 may be applied on top of each other. For example, the hydrophobic coating 131 may be applied directly onto the support surface and the hydrophilic coating 132 be applied on the hydrophobic coating 131. The hydrophobic coating 131 may cover the entire contact side 111 of the support surface, while the hydrophilic coating 132 covers specific areas of the hydrophobic coating 131, to form the pattern. By having the hydrophilic coating 132 only locally covering areas of the hydrophobic coating 131, thus exposing the hydrophobic coating 131 in other parts, the pattern of one or more hydrophilic and hydrophobic zones can be defined. Alternatively, the hydrophilic coating 132 can be applied directly on the support surface 110, with the hydrophobic coating 131 applied on top of the hydrophilic coating 132 in some areas.

In order to minimize thermal resistance of the coatings, the hydrophobic and hydrophilic coatings 131, 132 preferably have a relatively small thickness, e.g. a sub micrometer thickness. The hydrophobic coating 131 preferably has a layer thickness of 1-1000 nanometers, preferably 10-100 nanometers. The hydrophilic coating 132 preferably has a similar thickness, e.g. a layer thickness of 10-100 nanometers, preferably about 40-60 nanometers. The type of material also contributes to the thermal resistance of the hydrophobic and hydrophilic coatings 131, 132. The hydrophobic coating 132 preferably comprises Silicon dioxide, SiO2, or another material with water repelling properties and a relatively high thermal conductivity. The hydrophilic coating 132 material may comprise one or more of Molybdenum, Tungsten, Tantalum, Copper and Chromium, or any other material or alloy that has good water attracting properties and low thermal resistance.

The heater facility 120 is arranged for heating the applied substance at its contact surface with the contact side 111 of the support surface. The heater facility 120 preferably comprises a resistive heater layer 123 that is arranged between the base plate 115 of the support surface and the hydrophilic and hydrophobic coatings 131, 132. The resistive heater layer 123 e.g. comprises a plurality of serially arranged resistive heating elements for heating respective zones of the support surface 110, which heating elements have a temperature dependent resistance. Although not shown in the figures, the printing device 100 may further include a power supply to provide an electric power, and a selection module to alternately supply the electric power to a selected one of the serially arranged resistive heating elements.

A controller 150 is arranged for controlling the heater facility 120. Optionally, in case of a resistive heater layer, a voltage and current sensing facility may be configured to provide sense signals indicative for a voltage and a current of the supplied electric power. The controller 150 may then be configured to control a heat flux of each resistive heating element in response to the sense signals of the voltage and current sensors.

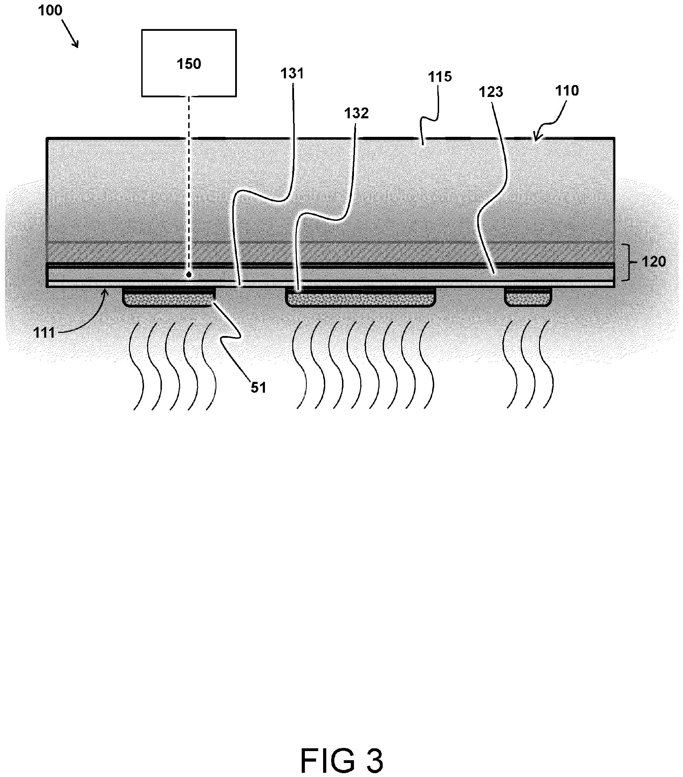

The controller 150 is arranged for controlling the heater facility 120 to perform a step of increasing a viscosity of the patterned substance that is applied on the support surface 110, by at least partially evaporating the high vapor pressure material with a low heat flux. FIG. 3 illustrates how after this step, the substance 50 is reduced to a higher viscosity substance 51. The viscosity of the substance is e.g. increased by a factor two or more.

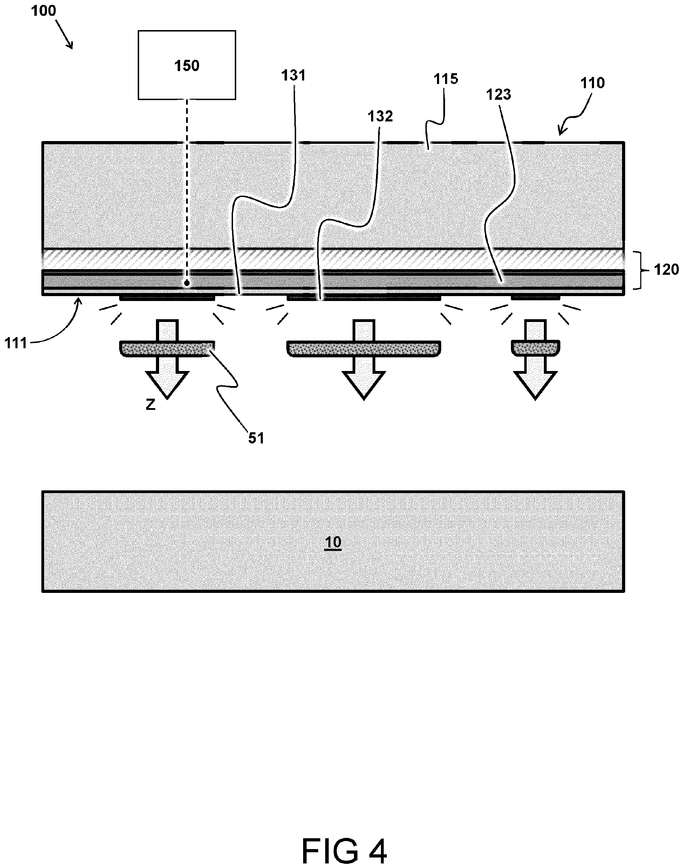

FIG. 4 illustrates how after the step of increasing the viscosity of the substance, the controller 150 controls the heater facility 120 to rapidly evaporate a part of the low vapor pressure material in the higher viscosity substance 51 with a high heat flux pulse at its contact surface with the support surface, with the purpose of inducing an evaporation that causes a transfer of a remainder of the patterned, higher viscosity substance 51 towards a target surface or acceptor substrate 10, e.g. in a transfer direction Z.

The printing device 100 optionally comprises a cooling facility for cooling the support surface 110, and the controller 150 may be arranged for controlling the heater facility and the cooling facility to maintain the support surface 110 at a predetermined temperature between the steps of increasing the viscosity and rapidly evaporating the patterned substance. For example, the support surface 110 may comprise cooling channels for conducting a cooling liquid, such as water. Therewith the support surface can be rapidly cooled down, or maintained at a low temperature. Alternatively, or additionally, a support structure for supporting the support surface 110 may comprise cooling channels for conducting a cooling liquid in proximity of the support surface 110. It can be favorable to maintain the support surface at a low temperature until the point in time that the substance is to be transferred so as to keep the viscosity of the substance at a high value.

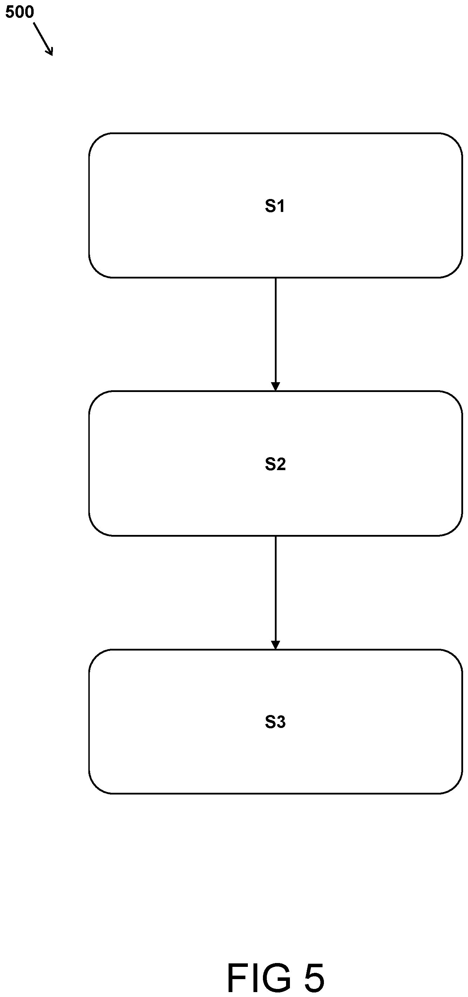

FIG. 5 represents an embodiment of a three step method 500 for transferring a pattern from a support surface onto a target surface, e.g. using the printing device 100 described herein. Or, in other words, the printing device 100 may be arranged for performing the method 500.

The support surface comprises a hydrophilic coating and a hydrophobic coating that form hydrophilic and hydrophobic zones on its contact side for attracting and repelling the substance, for thereby patterning the substance applied on the support surface, and the substance comprises at least one low vapor pressure material and at least one high vapor pressure material.

The method 500 comprises applying (step S1) a low viscous water based substance onto a contact side of the support surface, increasing (step S2) a viscosity of the patterned substance, by at least partially evaporating the high vapor pressure material with a low heat flux, and rapidly evaporating (step S3) a part of the low vapor pressure material with a high heat flux pulse at its contact surface with the support surface, for therewith inducing an evaporation that causes a transfer of a remainder of the patterned substance towards the target surface.

In some embodiments, when a resistive heater layer is provided between the support surface and the hydrophilic and hydrophobic coatings, at least step S3 of rapidly evaporating the substance is performed by the resistive heater layer. Preferably, step S2 of increasing the viscosity of the substance is also performed by the resistive heater layer. Alternatively, this step S2 can be performed by drying or curing the substance in another way, e.g. by decreasing the humidity or pressure of the surrounding atmosphere, or by using photonic energy from a light source such as a laser device directed at the contact side.

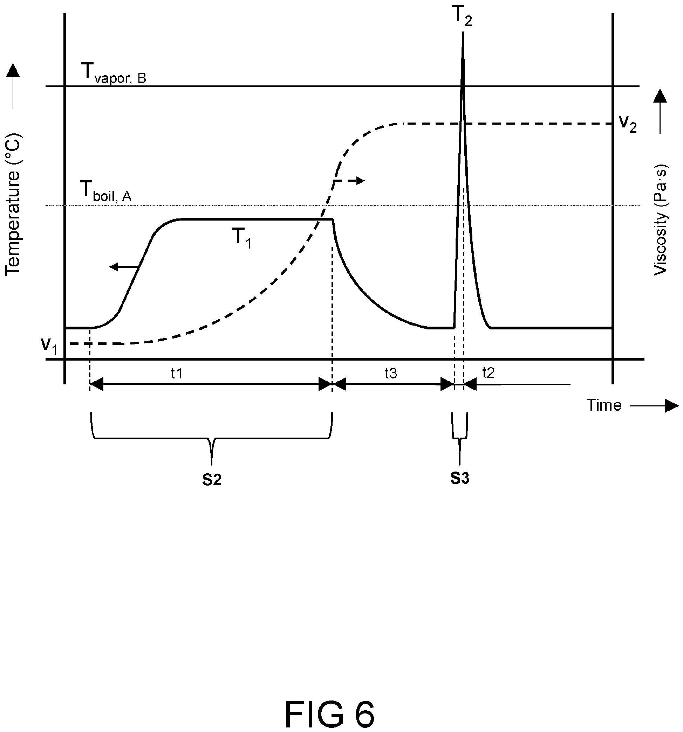

FIG. 6 shows that step S2 of increasing the viscosity of the patterned substance is performed by heating the substance to a first temperature T₁ during a first time period t₁, and step S3 of rapidly evaporating the substance is performed by heating a part of the substance to a second temperature T₂ during a second time period t₂. The second temperature T₂ is typically higher than the first temperature T₁, e.g. a factor two or more higher, and the second time period t₂ is significantly shorter than the first time period t₁. For example, the first time period t₁ is in the range of 0.1 - 1000 milliseconds, while the second time period t₂ is one or more orders of magnitude shorter, e.g. in a range of 0.1 - 100 microseconds. The first time period t₁ and the second time period t₂ are separated by a time interval t₃, which has a length of e.g. 1 - 1000 milliseconds, or more.

The first temperature T₁ is preferably lower than a boiling temperature T_{boil,A} of the high vapor pressure material, and the second temperature T₂ is preferably higher than a vaporization temperature T_{vapor,B} of the low vapor pressure material.

As a result of step S2, the viscosity of the substance may be increased from a low viscosity v₁ to a high viscosity v₂ that is higher by a factor two or more before the start of step S3, e.g. from a viscosity lower than 20 Pascal-second at 20 degrees Celsius to a viscosity higher than 40, 50 or 100 Pascal-Second, to even as much as about 1000 Pascal-second, at 20 degrees Celsius.

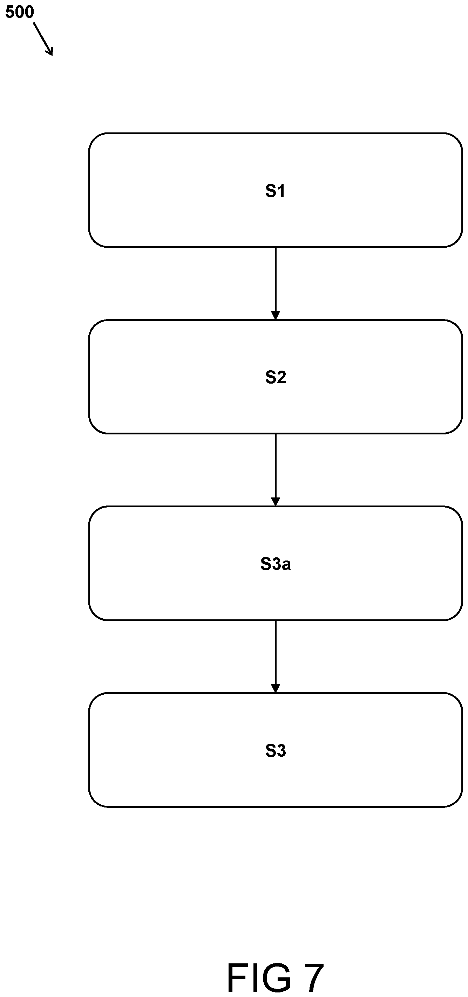

FIG. 7 illustrates another of further embodiment of the method 500, in which between step S2 of increasing the viscosity and step S3 of rapidly evaporating the patterned substance, a step S3a is introduced of cooling the support surface to maintain the support surface at a predetermined temperature.

It will be clear to the skilled person that the invention is not limited to any specific embodiment herein described and that combinations or modifications are possible, in as far as these can be considered within the scope of the appended claims. In the claims, any reference signs shall not be construed as limiting the claim.

The terms 'comprising' and 'including' when used in this description or the appended claims should not be construed in an exclusive or exhaustive sense but rather in an inclusive sense. Thus expression as 'including' or 'comprising' as used herein does not exclude the presence of other elements, additional structure or additional acts or steps in addition to those listed. Furthermore, the words 'a' and 'an' shall not be construed as limited to 'only one', but instead are used to mean 'at least one', and do not exclude a plurality. Features that are not specifically or explicitly described or claimed may additionally be included in the structure of the invention without departing from its scope.

Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. To the extent that structure, material, or acts are considered to be essential they are inexpressively indicated as such.

## Claims

1. A method for transferring a pattern from a support surface onto a target surface, comprising:
- applying a low viscous substance, with at least two phases, i.e. a carrier material and a functional material, onto the support surface; wherein the support surface comprises first zones that attract the substance and second zones that repel the substance, for thereby patterning the substance when applied on the support surface; wherein the substance comprises at least one low vapor pressure material and at least one high vapor pressure material;
- increasing a viscosity of the patterned substance, by at least partially evaporating the high vapor pressure material;
- rapidly evaporating a part of the low vapor pressure material with a high heat flux at its contact surface with the support surface, for therewith inducing an evaporation that causes a transfer of a remainder of the patterned substance towards the target surface.

2. The method according to claim **1,** further comprising the step of providing a resistive heater layer on the support surface, wherein at least the step of rapidly evaporating the substance is performed by the resistive heater layer.

3. The method according to any of the preceding claims, wherein the step of increasing the viscosity of the patterned substance is performed by heating the substance to a first temperature during a first time period, and wherein the step of rapidly evaporating the substance is performed by heating a part of the substance to a second temperature during a second time period, wherein the second temperature is higher than the first temperature, and wherein the second time period is shorter than the first time period.

4. The method according to claim 3, wherein the first temperature is lower than a boiling temperature of the high vapor pressure material, and wherein the second temperature is higher than a vaporization temperature of the low vapor pressure material.

5. The method according to any of the preceding claims, wherein between the steps of increasing the viscosity and rapidly evaporating the patterned substance, the method comprises a step of cooling the support surface to maintain the support surface at a predetermined temperature, and/or a step of increasing an ambient pressure to increase the vaporization temperature of the functional material.

6. The method according to any of the preceding claims, wherein the substance is applied onto the support surface with a viscosity less than 10 Pascal-second at 20 degrees Celsius.

7. The method according to any of the preceding claims, wherein the substance is a water based ink or an ink comprising an organic compound, wherein the organic compound is preferably a polyol.

8. A printing device for printing a low viscous substance, with at least two phases, i.e. a carrier material and a functional material, with a pattern onto a target surface, wherein the substance comprises at least one low vapor pressure material and at least one high vapor pressure material, wherein the printing device comprises:
- a support surface onto which the substance is to be applied;
- a heater facility arranged for heating the applied substance at its contact surface with the support surface;
- a controller arranged for controlling the heater facility;
wherein the support surface comprises first zones that attract the substance and second zones that repel the substance, for thereby patterning the substance when applied on the support surface;
wherein the controller is arranged for controlling the heater facility to:
- first increase a viscosity of the patterned substance, by at least partially evaporating the high vapor pressure material; and subsequently
- rapidly evaporate a part of the low vapor pressure material with a high heat flux at its contact surface with the support surface, for therewith inducing an evaporation that causes a transfer of a remainder of the patterned substance towards the target surface.

9. The printing device according to claim 8, wherein the first zones are provided by a first coating, and wherein the second zones are provided by a second coating.

10. The printing device according to claim 9, wherein the second coating has a layer thickness of 1-1000 nanometers.

11. The printing device according to claim 10, wherein the first coating has a layer thickness of 10-100 nanometers.

12. The printing device according to any of claims 9-11, wherein the second coating comprises Silicon dioxide, SiO₂, Silicon Nitride, Si₃N₄, or Aluminium Oxide, Al₂O₃.

13. The printing device according to any of claims 9-12, wherein the first coating comprises at least one of Molybdenum, Tungsten, Tantalum, Copper, and Chromium.

14. The printing device according to any of claims 9-13, wherein the heater facility comprises a resistive heater layer that is arranged between the support surface and the first and second coatings.

15. The printing device according to any of claims 8-14, wherein the printing device further comprises a cooling facility for cooling the support surface, and wherein the controller is arranged for controlling the heater facility and the cooling facility to maintain the support surface at a predetermined temperature between the steps of increasing the viscosity and rapidly evaporating the patterned substance.
